# EUROPEAN PATENT APPLICATION

(11) **EP 4 329 183 A1**
(43) Date of publication of application: **28.02.2024**
(21) Application number: 22790218.6
(22) Date of filing: 06.04.2022
(51) Int. Cl.: H02N 11/00, H01L 37/02, H02N 2/18, C04B 35/468

(54) **ELECTRICITY GENERATION METHOD, AND ELECTRICITY GENERATING SYSTEM**

(30) Priority: 22.04.2021 JP 2021072695; 05.08.2021 JP 2021129083
(71) Applicant: Kwansei Gakuin Educational Foundation, Nishinomiya-shi, Hyogo 662-8501 (JP)
(72) Inventor: TANAKA, Hirohisa, Sanda-shi, Hyogo 669-1337 (JP); HARAYAMA, Yuki, Sanda-shi, Hyogo 669-1337 (JP); NAGATANI, Tomomi, Sanda-shi, Hyogo 669-1337 (JP); YAMAGUCHI, Shoma, Sanda-shi, Hyogo 669-1337 (JP); ICHIKAWA, Takumi, Sanda-shi, Hyogo 669-1337 (JP)
(74) Representative: SSM Sandmair
(86) International application number: PCT/JP2022/017172
(87) International publication number: WO 2022/224825

(57) **Abstract**

A power-generating method of generating power from a power-generating element (2) is disclosed. An electric polarization state in the power-generating element (2) is changed by phase transition. First, an electric field is applied to the power-generating element (2) to change a phase transition temperature of the power-generating element (2) by an electric-field application unit (4) for applying the electric field to the power-generating element (2) without changing a temperature of the power-generating element (2). Then, the electric polarization state in the power-generating element (2) is changed by application of the electric field and control of the application, so that the power from the power-generating element (2) is generated.

## Description

### TECHNICAL FIELD

The present invention relates a power-generating method and a power-generating system.

### BACKGROUND ART

Various methods of reusing waste heat energy have been conventionally studied. For example, a power-generating system has been proposed which includes a heat source that produces temporal temperature variation, a first device (a dielectric) that becomes electrically polarized in accordance with the temperature variation of the heat source, and second devices (electrodes) arranged to be opposed to each other with the first device sandwiched therebetween for taking out power from the first device. Further, in the above power-generating system, applying voltage (an electric field) to the first device in accordance with temperature change of the first device has been also proposed (for example, see Patent Document 1).

### Citation List

### Patent Document

Patent Document 1
International Publication No. WO 2014/069045

### SUMMARY OF THE INVENTION

### PROBLEM TO BE SOLVED BY THE INVENTION

In power generation by the above power-generating system, it is necessary to change the temperature of the first device (the dielectric). However, it is not easy to find an environment that changes the temperature of the first device (the dielectric). In addition, even in an environment with the temperature change, the temperature of the first device may not follow the temperature change of the environment, depending on the mass and thermal conductivity of the first device itself.

The present invention is a power-generating method and a power-generating system that can generate power without preparing an environment that causes temperature change.

### MEANS FOR SOLVING THE PROBLEM

The present invention [1] includes a power-generating method of generating power from a power-generating element in which electric polarization state is changed by phase transition, the method includes: an electric-field application process of applying an electric field to the power-generating element to change a phase transition temperature of the power-generating element by an electric-field application unit for applying the electric field to the power-generating element without changing a temperature of the power-generating element; and a power-generating process of changing the electric polarization state in the power-generating element by application of the electric field and control of the application, to generate the power from the power-generating element.

The present invention [2] includes the power-generating method recited in [1], wherein the electric-field application process changes the phase transition temperature of the power-generating element to repeat a first state where the phase transition temperature exceeds an outside air temperature and a second state where the phase transition temperature is less than the outside air temperature.

The present invention [3] includes the power-generating method recited in [1] or [2], wherein a temperature difference between the phase transition temperature of the power-generating element to which no electric is applied and an outside air temperature of the power-generating element is 50°C or less.

The present invention [4] includes the power-generating method recited in any one of [1] to [3], wherein the power-generating element contains at least one selected from the group consisting of barium titanate [BaTiO₃], barium zirconate titanate [Ba (Zr,Ti)O₃], and barium calcium zirconate titanate [(Ba,Ca)(Zr,Ti)O₃].

The present invention [5] includes the power-generating method recited in [4], wherein the power-generating element further contains a doping rare earth element.

The present invention [6] includes the power-generating method recited in [5], wherein the doping rare earth element contains at least one selected from the group consisting of Ce, Y, and La.

The present invention [7] includes the power-generating method recited in [5] or [6], wherein the doping rare earth element contains Ce, and a content ratio of Ce with respect to a total amount of metal elements in the power-generating element is 0.00005 mol% or more and 50 mol% or less.

The present invention [8] includes the power-generating method recited in any one of [4] to [7], wherein the power-generating element is annealed in an oxidizing atmosphere.

The present invention [9] includes a power-generating system comprising a power-generating element whose electric polarization state is changed by phase transition and a power-generating unit for generating power from the power-generating element, wherein the power-generating unit includes: no temperature changing unit that changes an outside air temperature of the power-generating element; an electric-field application unit that applies an electric field to the power-generating element to change a phase transition temperature of the power-generating element; an extraction unit for extracting the power generated due to change of the electric polarization state in the power-generating element; and a control unit for controlling the electric field applied by the electric-field application unit, and the control unit applies the electric field to the power-generating element to cause change of the phase transition temperature of the power-generating element.

The present invention [10] includes the power-generating system recited in [9], wherein the control unit applies the electric field to the power-generating element to change the phase transition temperature of the power-generating element, causing a first state where the phase transition temperature exceeds the outside air temperature and a second state where the phase transition temperature is less than the outside air temperature to be repeated.

The present invention [11] includes the power-generating system recited in [9] or [10], wherein the power-generating element contains at least one selected from the group consisting of barium titanate [BaTiO₃], barium zirconate titanate [Ba(Zr,Ti)O₃], and barium calcium zirconate titanate [(Ba,Ca)(Zr,Ti)O₃].

The present invention [12] includes the power-generating system recited in [11], wherein the power-generating element further contains a doping rare earth element.

The present invention [13] includes the power-generating system recited in [12], wherein the doping rare earth element contains at least one selected from the group consisting of Ce, Y, and La.

The present invention [14] includes the power-generating system recited in [12] or [13], wherein the doping rare earth element contains Ce, and a content ratio of Ce with respect to a total amount of metal elements in the power-generating element is 0.00005 mol% or more and 50 mol% or less.

The present invention [15] includes the power-generating system recited in any one of [11] to [14], wherein the power-generating element is annealed in an oxidizing atmosphere.

### EFFECTS OF THE INVENTION

A power-generating method and a power-generating system according to the present invention apply an electric field to a power-generating element to change a phase transition temperature of the power-generating element without causing temperature change of the power-generating element, to generate power from the power-generating element. Therefore, power generation can be achieved without finding an environment that causes the temperature change of the power-generating element. Further, a method of changing the electric field applied to the power-generating element to control electric polarization has less restrictions on the mass and the thermal conductivity of the power-generating element as compared with a method of changing the temperature of the power-generating element, and is excellent in applicability.

### BRIEF DESCRIPTION OF THE DRAWINGS

FIG. 1 is a schematic configuration diagram of an embodiment of a power-generating system according to the present invention.
FIG. 2 is a graph illustrating the relation between the net generated power obtained in Example 1 and a temperature condition.
FIG. 3 is a graph illustrating the relation between the net generated power obtained in Comparative Example 1 and a temperature condition.
FIG. 4 is a graph illustrating the relation between the net generated power obtained in Example 2 and a temperature condition.
FIG. 5 is a graph illustrating the relation between the net generated power obtained in Example 3 and a temperature condition.
FIG. 6 is a graph illustrating the relation between the net generated power obtained in Example 4 and a temperature condition.
FIG. 7 is a graph illustrating the relation between the net generated power obtained in Example 5 and a temperature condition.
FIG. 8 is a graph illustrating the relation between the net generated power obtained in Example 6 and a temperature condition.
FIG. 9 is a graph illustrating the relation between the net generated power obtained in Example 7 and a temperature condition.
FIG. 10 is a graph illustrating the relation between the net generated power obtained in Example 8 and a temperature condition.
FIG. 11 is a graph illustrating the relation between the net generated power obtained in Example 9 and a temperature condition.
FIG. 12 is a graph illustrating the relation between the net generated power obtained in Example 10 and a temperature condition.
FIG. 13 is a graph illustrating the relation between the net generated power obtained in Example 11 and a temperature condition.
FIG. 14 is an operation diagram illustrating operations of a power supply, a recovery switch, and a recovery switch in Examples 12 to 14 and Comparative Example 2.
FIG. 15 is a graph illustrating the relation among the net generated power, the strength of an applied electric field, and the frequency of the applied electric field in Examples 12 to 14 and Comparative Example 2.

### EMBODIMENT OF THE INVENTION

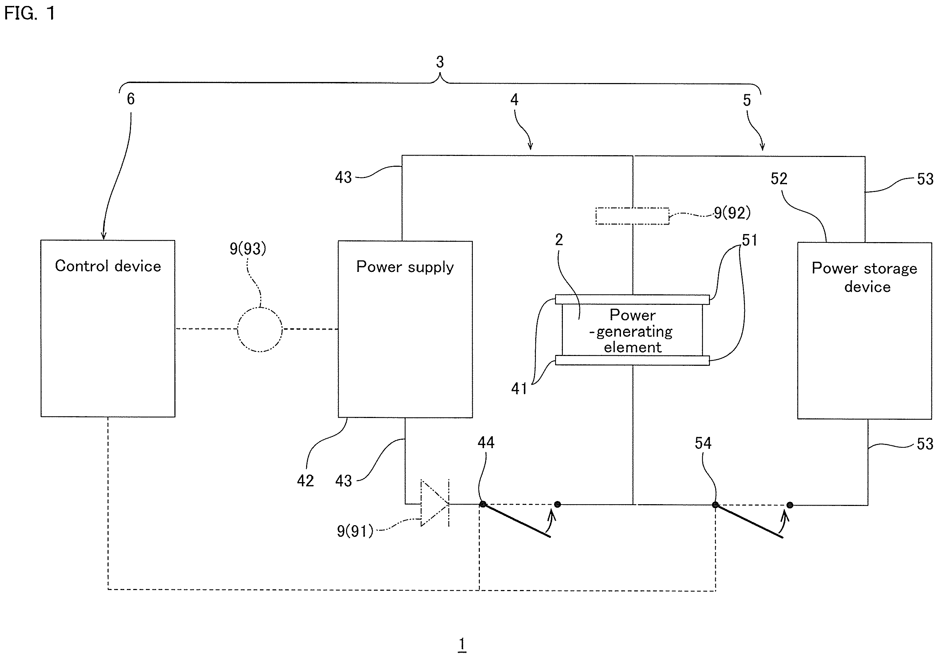

FIG. 1 is a schematic configuration diagram of an embodiment of a power-generating system according to the present invention. In FIG. 1, a power-generating system 1 includes a power-generating element 2 and a power generator 3 as a power generation unit (a power generation unit).

The power-generating element 2 is a device whose electric polarization state is changed by phase transition. Electric polarization is a phenomenon in which dielectric polarization is caused by displacement of positive and negative ions associated with distortion of crystals (change in steric symmetry), thus causing a potential difference.

Examples of the power-generating element 2 include materials that exhibit the pyroelectric effect and/or the piezoelectric effect. One example of such a material is a dielectric. Examples of the dielectric include lead-containing inorganic derivatives, lead-free inorganic derivatives, and polymeric organic derivatives.

Examples of the lead-containing inorganic derivatives include a lead-containing dielectric, and a metal-doped dielectric obtained by doping the dielectric with a doping metal (excluding a rare earth element described later). More specific examples of the lead-containing inorganic derivatives include lead titanate [PbTiO₃], lead zirconate [PBZrO₃], lead zirconate titanate [Pb(Zr,Ti)O₃], lead manganate niobate [Pb(Mg,Nb)O₃], lead zinc niobate [Pb(Zn,Nb)O₃], lead magnesium tantalate [Pb(Mg,Ta)O₃], and lead indium niobate [Pb(In,Nb)O₃]. Examples of the lead-containing inorganic derivatives further include a rare-earth-doped material obtained by doping the above-described dielectric and/or the metal-doped body of above-described dielectric with a doping rare earth element described later. These may be used alone or in combination of two or more.

Examples of the lead-free inorganic derivatives include a lead-free dielectric and a metal-doped body of that dielectric obtained by doping that dielectric with a doping metal (excluding a rare earth element described later). More specific examples of the lead-free inorganic derivative include barium titanate [BaTiO₃], barium zirconate titanate [Ba(Zr,Ti)O₃], barium calcium titanate [(Ba,Ca)TiO₃], barium calcium zirconate titanate [(Ba,Ca)(Zr,Ti)O₃], calcium titanate [CaTiO₃], quartz [SiO₂], zinc oxide [ZnO], potassium sodium tartrate [KNaC₄H₄O₆], lithium niobate [LiNbO₃], lithium tantalate [LiTaO₃], lithium tetraborate [Li₂B₄O₇], aluminum nitride [AlN], tourmaline [tourmaline], polyvinylidene fluoride [PVDF], calcium vanadate [Ca₃(VO₄)₂], lithium tantalate niobate [Li(Nb,Ta)O₃], calcium tantalate niobate [Ca₃{(Nb,Ta)O₄}₂], potassium niobate [KNbO₃], magnesium niobate [MgNbO₃], calcium niobate [CaNbO₃], potassium sodium niobate [(K,N)NbO₃], sodium bismuth potassium niobate [Bi(K,Na)NbO₃], strontium potassium sodium niobate [Sr(K,Na)NbO₃], barium potassium sodium niobate [Ba,(K,Na)NbO₃], lithium potassium sodium niobate [Li,(K,Na)NbO₃], sodium strontium niobate [Sr₂NaNb₅O₁₅], strontium calcium sodium niobate [(Sr,Ca)NaNb₅O₁₅], barium sodium niobate [Ba₂NaNbO₁₅], and barium niobate [Ba₂Nb₂O₆]. Further, examples of the lead-free inorganic derivatives also include rare-earth-doped materials obtained by doping the above-described dielectric and/or the metal-doped body of that dielectric with a doping rare earth element described later. These may be used alone or in combination of two or more.

Examples of the polymeric organic derivatives include a homopolymer and a copolymer of vinylidene fluoride. Examples of the homopolymer include polyvinylidene fluoride (PVD). Examples of the copolymer include a copolymer of vinylidene fluoride (VDF) and trifluoroethylene (TrFE). These may be used alone or in combination of two or more.

These dielectrics may be used alone or in combination of two or more. From the environmental point of view, lead-free inorganic dielectrics and polymeric organic dielectrics are preferable. The lead-free inorganic dielectrics and the polymeric organic dielectrics meet lead-free requirements and are environmentally friendly. From the viewpoint of power generation efficiency, the lead-free inorganic dielectrics are more preferable.

Preferable examples of the lead-free inorganic dielectrics include dielectrics having a perovskite crystal structure, and more preferable examples include barium titanate [BaTiO₃], barium zirconate titanate [Ba(Zr,Ti) O₃], and barium calcium zirconate titanate [(Ba,Ca)(Zr,Ti)O₃]. That is, from the viewpoint of power generation efficiency, the power generating element 2 preferably contains at least one selected from the group consisting of barium titanate [BaTiO₃], barium zirconate titanate [Ba(Zr,Ti)O₃], and barium calcium zirconate titanate [(Ba,Ca)(Zr,Ti)O₃].

From the viewpoint of power generation efficiency, the power-generating element 2 more preferably contains barium zirconate titanate [Ba(Zr,Ti)O₃] and/or barium calcium zirconate titanate [(Ba,Ca)(Zr,Ti)O₃].

From the viewpoint of power generation efficiency, the power-generating element 2 further preferably contains barium zirconate titanate [Ba(Zr,Ti)O₃]. From the viewpoint of power generation efficiency, the power-generating element 2 is especially preferably consisting of barium zirconate titanate [Ba(Zr,Ti)O₃].

Further, from the viewpoint of power generation efficiency, the power-generating element 2 preferably contains a doping rare earth element. In other words, preferable examples of the power-generating element 2 include a dielectric containing a doping rare earth element (hereinafter, a rare-earth-doped dielectric).

Examples of the rare-earth-doped dielectric include the rare-earth-doped body of the above-described lead-containing inorganic dielectrics and the rare-earth-doped body of the above-described lead-free inorganic dielectrics, and preferable examples include the rare-earth-doped body of the above-described lead-free inorganic dielectrics.

Examples of the rare earth element with which the dielectric is doped (hereinafter, referred to as a doping rare earth element) include scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu). These may be used alone or in combination of two or more. Preferable examples of the doping rare earth element include Ce, Y, and La. In other words, the doping rare earth element preferably contains at least one selected from the group consisting of Ce, Y, and La.

Ce is especially preferable as the doping rare earth element from the viewpoint of power generation efficiency. More specifically, the doping rare earth element contains at least Ce especially preferably. In this case, the doping rare earth element can contain Y and/or La in addition to Ce. In other words, as the doping rare earth element, it is preferable to use Ce alone and Ce may be used in combination with Y and/or La.

Preferable examples of the rare-earth-doped dielectrics include rare-earth-doped [Ba(Zr,Ti)O₃], and more preferable examples include Ce-doped [Ba(Zr,Ti)O₃], Y-doped [Ba(Zr,Ti)O₃], La-doped [Ba(Zr,Ti)O₃], Ce, Y-doped [Ba(Zr,Ti)O₃], and Ce, La-doped [Ba(Zr,Ti)O₃].

In [Ba(Zr,Ti)O₃], Ce is preferably substituted for a part of Zr and/or a part of Ti. That is, Ce-doped [Ba(Zr,Ti)O₃] is preferably represented as [Ba(Zr,Ti,Ce)O₃].

Further, in [Ba(Zr,Ti)O₃], Y is preferably substituted for a part of Zr and/or a part of Ti. That is, Y-doped [Ba(Zr,Ti)O₃] is preferably represented as [Ba(Zr,Ti,Y)O₃]. Furthermore, Ce, Y-doped [Ba(Zr,Ti)O₃] is preferably represented as [Ba(Zr,Ti,Ce,Y)O₃].

In addition, in [Ba(Zr,Ti)O₃], La is preferably substituted for a part of Ba. That is, La-doped [Ba(Zr,Ti)O₃] is preferably represented as [(Ba,La)(Zr,Ti)O₃]. Furthermore, Ce, La-doped [Ba(Zr,Ti)O₃] is preferably represented as [(Ba,La)(Zr,Ti,Ce)O₃].

The content ratio of the doping rare earth element (the total amount of the doping rare earth elements when used in combination) in the rare-earth-doped dielectric with respect to the total amount (total number of moles) of metal elements in a power-generating element (the rare-earth-doped dielectric) is, for example, 0.00005 mol% or more, preferably 0.0001 mol% or more, more preferably 0.001 mol% or more, still more preferably 0.005 mol% or more, from the viewpoint of power generation efficiency.

Further, the content ratio of the doping rare earth element (the total amount of the doping rare earth elements when used in combination) in the rare-earth-doped dielectric with respect to the total amount (total number of moles) of metal elements in the power-generating element (the rare-earth-doped dielectric) is, for example, 50 mol% or less, preferably 10 mol% or less, more preferably 1 mol% or less, still more preferably 0.1 mol% or less, especially preferably 0.01 mol% or less, from the viewpoint of power generation efficiency.

In addition, in the case where the doping rare earth element contains Ce, the content ratio of Ce with respect to the total amount (total number of moles) of metal elements in the power-generating element (the rare-earth-doped dielectric) is, for example, 0.00005 mol% or more, preferably 0.0001 mol% or more, more preferably 0.001 mol% or more, still more preferably 0.005 mol% or more, from the viewpoint of power generation efficiency.

In the case where the doping rare earth element contains Ce, the content ratio of Ce with respect to the total amount (total number of moles) of metal elements in the power-generating element (the rare-earth-doped dielectric) is, for example, 50 mol% or less, preferably 10 mol% or less, more preferably 1 mol% or less, still more preferably 0.1 mol% or less, especially preferably 0.01 mol% or less, from the viewpoint of power generation efficiency.

In addition, in the case where the doping rare earth element contains Y, the content ratio of Y with respect to the total amount (total number of moles) of metal elements in the power-generating element (the rare-earth-doped dielectric) is, for example, 0.00005 mol% or more, preferably 0.0001 mol% or more, more preferably 0.0005 mol% or more, still more preferably 0.001 mol% or more, from the viewpoint of power generation efficiency.

In the case where the doping rare earth element contains Y, the content ratio of Y with respect to the total amount (total number of moles) of metal elements in the power-generating element (the rare-earth-doped dielectric) is, for example, 10 mol% or less, preferably 1 mol% or less, more preferably 0.1 mol% or less, still more preferably 0.05 mol% or less, especially preferably 0.01 mol% or less, from the viewpoint of power generation efficiency.

In addition, in the case where the doping rare earth element contains La, the content ratio of La with respect to the total amount (total number of moles) of metal elements in the power-generating element (the rare-earth-doped dielectric) is, for example, 0.00005 mol% or more, preferably 0.0001 mol% or more, more preferably 0.0005 mol% or more, still more preferably 0.001 mol% or more, from the viewpoint of power generation efficiency.

In the case where the doping rare earth element contains La, the content ratio of La with respect to the total amount (total number of moles) of metal elements in the power-generating element (the rare-earth-doped dielectric) is, for example, 10 mol% or less, preferably 5 mol% or less, more preferably 1 mol% or less, still more preferably 0.5 mol% or less, especially preferably 0.05 mol% or less, from the viewpoint of power generation efficiency.

A producing method of the dielectric, a producing method of the metal-doped dielectric, and a producing method of the rare-earth-doped body of the dielectric or the metal-doped dielectric are not particularly limited. For example, first, main raw materials containing metal elements of the dielectric are mixed at an appropriate ratio. If necessary, the main raw materials containing the metal elements of the dielectric, a doping metal raw material containing a doping metal (excluding a rare earth element), and/or a doping rare earth raw material containing a doping rare earth element are mixed at the above-described ratio. Examples of the main raw materials, the doping metal raw material, and the doping rare earth raw material include known compounds and complexes, and more specific examples include oxides, carbonates, oxychlorides, and alkoxide complexes. The mixing method is not particularly limited, and a known method is employed. A raw material mixture is thus obtained.

Next, the raw material mixture is calcined (primary firing) in the presence of oxygen. The calcination temperature is, for example, 600°C or more, preferably 800°C or more. The calcination temperature is, for example, 1300°C or less, preferably 1 100°C or less. The calcination time is, for example, 30 minutes or more, preferably 2 hours or more. Further, the calcination time is, for example, 12 hours or less, preferably 6 hours or less. Calcined powder (primary fired powder) is thus obtained.

Next, the calcined powder is pulverized if necessary, and then molded to pressure molding, so that a green compact is obtained. Thereafter, the green compact is fired (main firing, secondary firing) to be sintered. The firing temperature is higher than the calcination temperature and is, for example, 800°C or more, preferably 1000°C or more. The firing temperature is, for example, 1800°C or less, preferably 1600°C or less. The firing time is, for example, 1 hour or more, preferably 2 hours or more. The firing time is, for example, 24 hours or less, preferably 12 hours or less. Thus, a dense sintered body (main fired body, secondary fired body) is obtained.

As a result, a sintered dielectric (containing a doping rare earth element, if necessary) can be obtained as the power-generating element 2.

The sintered dielectric (containing a doping rare earth element, if necessary) as the power-generating element 2 can also be obtained by firing (main firing) and sintering a commercially available dielectric under the above-described conditions.

The power-generating element 2 is annealed in an oxidizing atmosphere, if necessary. For example, in the case where the power-generating element 2 has a perovskite crystal structure, the power-generating element 2 is preferably annealed. That is, the power-generating element 2 is preferably an annealed dielectric having a perovskite crystal structure. By the annealing, oxygen lattice defects of the perovskite crystal structure can be repaired, so that the sintered dielectric having a more preferable lattice structure can be obtained. As a result, more excellent power generation performance is obtained.

In the annealing, the oxidizing atmosphere is, for example, in the air, preferably in a flow of the air, more preferably in an atmosphere in which the oxygen concentration is adjusted to be higher than in the air by an atmosphere firing furnace. In such a case, the oxygen concentration (on a volume basis) relative to the entire gas filling the atmosphere firing furnace is, for example, 30% or more, preferably 50% or more. The annealing temperature is, for example, 600°C or more, preferably 800°C or more. The annealing temperature is, for example, 1400°C or less, preferably 1200°C or less. The annealing time is, for example, 5 minutes or more, preferably 10 minutes or more. The annealing time is, for example, 24 hours or less, preferably 12 hours or less, more preferably 3 hours or less.

The power-generating element 2 is subjected to polarization treatment, if necessary. The power-generating element 2 is preferably subjected to polarization treatment. More excellent power generation performance is obtained by the polarization treatment.

The strength of an electric field applied in the polarization treatment is, for example, 500 V/mm or more, preferably 1 kV/mm or more, more preferably 10 kV/mm or more. The strength of the electric field is, for example, 200 kV/mm or less, preferably 100 kV/mm or less. The polarization treatment time is, for example, 1 minute or more, preferably 5 minutes or more. The polarization treatment time is, for example, 5 hours or less, preferably 1 hour or less.

The power-generating element 2 has a phase transition temperature. The phase transition temperature is a temperature at which the phase of the power-generating element 2 is changed, and the electric polarization state in the power-generating element 2 is changed. In other words, the power-generating element 2 undergoes phase transition in accordance with the relation between the outside air temperature (environmental temperature) and the phase transition temperature. In the power-generating element 2, the electric polarization state is changed by phase transition. That is, the electric polarization state in the power-generating element 2 is greatly changed before and after the phase transition temperature. The phase transition temperature of the power-generating element 2 is set in accordance with the material of the power-generating element 2 in an appropriate manner. The power-generating element 2 may have one phase transition temperature or a plurality of phase transition temperatures. The phase transition is generally believed to be governed by temperature and pressure.

As will be described in detail later, the phase transition temperature of the power-generating element 2 changes when an electric field is applied to the power-generating element 2. The above-described phase transition temperature is a phase transition temperature of the power-generating element 2 to which no electric field is applied.

The shape and size of the power-generating element 2 are not particularly limited, and are appropriately set according to the purpose and application. The power generating element 2 has, for example, a rectangular parallelepiped shape, a cubic shape, a sheet shape, a disk shape, a thin film shape, a spherical shape, and a massive shape, preferably a sheet shape, a disk shape, and a thin film shape. In the case where the power-generating element 2 has a sheet shape or a disk shape, the thickness thereof is preferably smaller and is, for example, 2.0 mm or less, preferably 0.5 mm or less. In the case where the power-generating element 2 has a thin film shape, the thickness thereof is, for example, 0.1 mm or less.

The power generator 3 includes an electric-field application device 4 as an electric-field application unit (an electric-field application unit), an extraction device 5 as an extraction unit (an extraction unit), and a control device 6 as a control unit (a control unit).

The power generator 3 does not include a temperature changing unit (a temperature changing unit) that changes the outside air temperature of the power-generating element 2. More specifically, the power generator 3 does not include a heater that heats the power-generating element 2 and a cooler that cools the power-generating element 2. Therefore, in the power-generating system 1, the power-generating element 2 is not heated or cooled actively. Consequently, the temperature of the power-generating element 2 does not change or follows the outside air temperature (environmental temperature) of an environment where the power-generating element 2 is arranged.

The outside air temperature (environmental temperature) is set in accordance with the material of the power-generating element 2 in an appropriate manner. The outside air temperature is usually 0°C or more and 350°C or less.

The electric-field application device 4 applies an electric field to the power-generating element 2 to change the phase transition temperature of the power-generating element 2. The electric-field application device 4 is electrically connected to the power-generating element 2 in order to apply voltage to the power-generating element 2. More specifically, the electric-field application device 4 includes a pair of electrodes 41 opposed to each other with the power-generating element 2 sandwiched therebetween, a power supply 42 for applying an electric field to the power-generating element 2, and a conducting wire 43 that connects the electrodes 41 and the power supply 42 to each other. The power supply 42 and the power-generating element 2 are thus electrically connected to each other.

The power supply 42 is electrically connected to the control device 6 (described later). The control device 6 (described later) controls output of the power supply 42. The strength of the electric field applied to the power-generating element 2 is thus controlled by the control device 6 (described later) (see broken line in FIG. 1).

An application switch 44 is intervened in the conducting wire 43. The application switch 44 is electrically connected to the control device 6 (described later). The control device 6 (described later) controls opening and closing of the application switch 44. The timing of application of the electric field to the power-generating element 2 is thus controlled by the control device 6 (described later) (see broken line in FIG. 1).

The extraction device 5 is a device for extracting power generated due to change of the electric polarization state in the power-generating element 2. The extraction device 5 is electrically connected to the power-generating element 2 in order to extract the power generated in the power-generating element 2.

The extraction device 5 directly uses and/or stores the power generated in the power-generating element 2, for example. In the case where the extraction device 5 directly uses the power, the extraction device 5 includes electric equipment that consumes the power to operate. In the case where the extraction device 5 stores the power, the extraction device 5 includes a power storage device. The electric equipment and the power storage device may be used in combination, as necessary. For example, the extraction device 5 includes the power storage device in FIG. 1. More specifically, the extraction device 5 includes a pair of electrodes 51 opposed to each other with the power-generating element 2 sandwiched therebetween, a power storage device 52 that stores the extracted power, and a conducting wire 53 that connects the electrodes 51 and the power storage device 52 to each other. The power storage device 52 and the power-generating element 2 are thus electrically connected to each other.

The power storage device 52 is not particularly limited as long as it can store the power extracted from the power-generating element 2, and is, for example, a condenser (a capacitor) or a battery, and preferably a condenser.

A recovery switch 54 is intervened in the conducting wire 53. The recovery switch 54 is electrically connected to the control device 6 (described later). The control device 6 (described later) controls opening and closing of the recovery switch 54. The timing of recovering the power from the power-generating element 2 is thus controlled by the control device 6 (described later) (see broken line in FIG. 1).

The electrodes 51 may be identical to the electrodes 41. That is, the pair of electrodes 41 sandwiching the power-generating element 2 therebetween may also be used as the electrodes 51. Further, a part of the conducting wire 43 connected to the electrodes 41 may also be used as the conducting wire 53.

The control device 6 is a unit that executes electrical control in the power-generating system 1. The control device 6 is provided for controlling an electric field applied by the electric-field application device 4. The control device 6 is also provided for controlling the timing of recovering power by the extraction device 5. The control device 6 is configured by a microcomputer provided with a CPU, a ROM, a RAM, and the like.

The control device 6 is electrically connected to the electric-field application device 4. More specifically, the control device 6 is electrically connected to the power supply 42. The control device 6 controls output of the power supply 42, thereby controlling the strength of an electric field applied to the power-generating element 2.

The control device 6 is also electrically connected to the application switch 44. The control device 6 thus controls opening and closing of the application switch 44. The control device 6 is also electrically connected to the recovery switch 54. The control device 6 thus controls opening and closing of the recovery switch 54.

The control device 6 has a control program. The control program includes a strength control program for controlling the output of the power supply 42 to control the strength of the electric field applied to the power-generating element 2 to a desired strength. The control program also includes an application control program for controlling the timings of opening and closing of the application switch 44 in a desired manner. The control program further includes a recovery control program for controlling the timings of opening and closing of the recovery switch 54 in a desired manner. These control programs are created by a known method and stored in the control device 6.

The power-generating system 1 may include a desired auxiliary part 9 as illustrated with virtual line (long dashed double-short dashed line) in FIG. 1, as necessary. Examples of the auxiliary part 9 include a diode, a condenser, a low-pass filter, a voltmeter, a resistor, a coil, a relay, and an earth. The auxiliary part is intervened at a desired position depending on the type thereof, as appropriate. For example, a diode 91 as the auxiliary part 9 can be intervened in the conducting wire 43 between the power supply 42 and the power-generating element 2. Further, a condenser 92 as the auxiliary part 9 can be intervened in the conducting wire 43 between the power supply 42 and the power-generating element 2, for example. Furthermore, a low-pass filter 93 as the auxiliary part 9 can be intervened between the control device 6 and the power supply 42, for example.

In the power-generating system 1 thus configured, the control device 6 controls the electric-field application device 4, thereby applying an electric field to the power-generating element 2 to change the phase transition temperature of the power-generating element 2. Consequently, the control device 6 causes the power-generating element 2 to be electrically polarized without heating and cooling the power-generating element 2 actively, to generate power in the power-generating element 2.

A detailed description is provided below for a power-generating method of generating power from the power-generating element 2 in which the electric polarization state is changed by phase transition.

In this method, first, the power-generating element 2 is selected which has the phase transition temperature depending on the outside air temperature (environmental temperature) of the power-generating element 2. A temperature difference between the phase transition temperature of the power-generating element 2 to which no electric field is applied and the outside air temperature of the power-generating element 2 is set depending on purpose and use, as appropriate. The temperature difference between the phase transition temperature of the power-generating element 2 to which no electric field is applied and the outside air temperature of the power-generating element 2 is, for example, 1°C or more, preferably 5°C or more. Further, the temperature difference between the phase transition temperature of the power-generating element 2 to which no electric field is applied and the outside air temperature of the power-generating element 2 is, for example, 50°C or less, preferably 30°C or less. When the temperature difference falls within the range described above, power generation can be performed with excellent efficiency. The power-generating element 2 is arranged between the electrodes 41 (the electrodes 51) in the power generator 3 illustrated in FIG. 1.

In this method, an electric field is applied to the power-generating element 2. More specifically, the electric field is applied to the power-generating element 2 by the electric-field application device 4 to change the phase transition temperature of the power-generating element 2 without changing the temperature of the power-generating element 2 (an electric-field application process).

That is, the application switch 44 is kept closed by the control device 6 in this process. The recovery switch 54 is kept open by the control device 6. The electric field is applied to the power-generating element 2 while the output of the power supply 42 and the strength of the electric field are controlled by the control device 6. The output of the power supply 42 and the strength of the electric field are set depending on the type of the power-generating element 2 and the outside air temperature of the power-generating element 2 in an appropriate manner.

Thereafter, in this power-generating method, the electric polarization state in the power-generating element 2 is changed by application of the electric field to the power-generating element 2 and control of that application. Power is thus generated from the power-generating element (a power-generating process).

That is, the phase transition temperature of the power-generating element 2 when any electric field is applied to the power-generating element 2 and that when no electric field is applied to the power-generating element 2 are different from each other.

More specifically, the phase transition temperature of the power-generating element 2 when any electric field is applied (electric field ON) is higher than that when no electric field is applied (electric field OFF).

Therefore, by controlling application of the electric field to the power-generating element 2 and stop of the application (electric field ON/ electric field OFF), the phase transition temperature of the power-generating element 2 can be changed without causing the temperature change of the power-generating element 2.

Further, the phase transition temperature of the power-generating element 2 when a relatively strong electric field is applied (strong electric field) is higher than that when a relatively weak electric field is applied (weak electric field).

Therefore, by controlling the strength of the electric field applied to the power-generating element 2 (weak electric field/ strong electric field), the phase transition temperature of the power-generating element 2 can be changed without causing the temperature change of the power-generating element 2.

In this method, either the method of controlling application of an electric field to the power-generating element 2 and stop of the application (electric field ON/ electric field OFF) or the method of controlling the strength of an electric field applied to the power-generating element 2 (weak electric field/ strong electric field) may be employed.

In such a method, a state where as a result of applying an electric field to the power-generating element 2 (electric field ON) or applying a relatively strong electric field to the power-generating element 2 (strong electric field), the phase transition temperature of the power-generating element 2 becomes relatively high and a state where as a result of not applying an electric field to the power-generating element 2 (electric field OFF) or applying a relatively weak electric field to the power-generating element 2 (weak electric field), the phase transition temperature of the power-generating element 2 becomes relatively low are repeated with a desired period.

In the following description, the state where the phase transition temperature of the power-generating element 2 is relatively high is referred to as a first state. The state where the phase transition temperature of the power-generating element 2 is relatively low is referred to as a second state. A repeating cycle of the first state and the second state is referred to as an electric-field application cycle.

In the electric-field application cycle, even after application of an electric field is started, a boost period during which voltage is not sufficiently raised and the phase transition temperature is not changed is the second state where the phase transition temperature of the power-generating element 2 is relatively low. Further, even after application of an electric field is stopped, a step-down period during which voltage is not sufficiently lowered and the phase transition temperature is not changed is the first state where the phase transition temperature of the power-generating element 2 is relatively high.

In the first state where the phase transition temperature is relatively high, the phase transition temperature of the power-generating element 2 is set depending on the material, the outside air temperature, and the outside pressure of the power-generating element 2 and an electric field condition, as appropriate.

In the second state where the phase transition temperature is relatively low, the phase transition temperature of the power-generating element 2 is set depending on the material, the outside air temperature, and the outside pressure of the power-generating element 2 and an electric field condition, as appropriate.

For example, both the phase transition temperature of the power-generating element 2 in the first state and the phase transition temperature of the power-generating element 2 in the second state may be equal to or higher than the outside air temperature. Further, both the phase transition temperature of the power-generating element 2 in the first state and the phase transition temperature of the power-generating element 2 in the second state may be equal to or lower than the outside air temperature, for example. That is, the power-generating element 2 may not undergo phase transition between the first state and the second state.

From the viewpoint of power generation efficiency, the power-generating element 2 preferably undergoes phase transition between the first state and the second state. More specifically, it is preferable from the viewpoint of power generation efficiency that the phase transition temperature of the power-generating element 2 exceeds the outside air temperature in the first state. Further, it is preferable from the viewpoint of power generation efficiency that the phase transition temperature of the power-generating element 2 is less than the outside air temperature in the second state.

In other words, the control device 6 applies an electric field to the power-generating element 2 so as to change the phase transition temperature of the power-generating element 2 without changing the temperature of the power-generating element 2 and to repeat the first state where the phase transition temperature exceeds the outside air temperature and the second state where the phase transition temperature is less than the outside air temperature. That is, the control device 6 applies an electric field to the power-generating element 2 in such a manner that the phase transition temperature of the power-generating element 2 changes across the outside air temperature.

In such a case, the phase transition temperature in the first state is, for example, [the outside air temperature + 0.1°C] or more, preferably [the outside air temperature + 5°C] or more and is, for example, [the outside air temperature + 50°C] or less, preferably [the outside air temperature + 30°C] or less.

The phase transition temperature in the second state is, for example, [the outside air temperature - 0°C] or less, preferably [the outside air temperature - 5°C] or less and is, for example, [the outside air temperature - 50°C] or more, preferably [the outside air temperature - 30°C] or more.

In the electric-field application cycle, the duration of the first state of the power-generating element 2 is not particularly limited but is, for example, 1/200000 seconds or more, preferably 1/2000 seconds or more per cycle. In the electric-field application cycle, the duration of the first state of the power-generating element 2 is not particularly limited but is, for example, 5 seconds or less, preferably 1 second or less per cycle.

Further, in the electric-field application cycle, the duration of the second state of the power-generating element 2 is, for example, 1/200000 seconds or more, preferably 1/2000 seconds or more per cycle. In the electric-field application cycle, the duration of the second state of the power-generating element 2 is, for example, 5 seconds or less, preferably 1 second or less per cycle.

Further, in one cycle, the duration of the second state of the power-generating element 2 to the duration of the first state of the power-generating element 2 (e.g., 1 second) is, for example, 0.5 times or more, preferably twice or more (e.g., 0.5 seconds or more, preferably 2 seconds or more).

In addition, a required time per cycle is, for example, 1/100000 seconds or more, preferably 1/1000 seconds or more. In addition, the required time per cycle is, for example, 10 seconds or less, preferably 2 seconds or less.

In other words, the frequency of the electric-field application cycle is, for example, 0.1 Hz or more, preferably 0.5 Hz or more, more preferably 1.0 Hz or more, still more preferably 1.5 Hz or more and is, for example, 100000 Hz or less, preferably 1000 Hz or less.

By repeating the first state and the second state in the power-generating element 2, the temperature difference between the outside air temperature (environmental temperature) of the power-generating element 2 and the phase transition temperature of the power-generating element 2 fluctuates. In accordance with fluctuation of the temperature difference, the power-generating element 2 undergoes phase transition in association with change of the polarization state.

That is, in the power-generating element 2, the crystalline state in the first state and that in the second state are different from each other, for example. Therefore, by repeating the first state and the second state in the power-generating element 2, the crystalline state of the power-generating element 2 can be changed repeatedly, so that the electric polarization state in the power-generating element 2 can be changed repeatedly. As a result, power is generated in the power-generating element 2.

The crystalline state of the power-generating element 2 in the first state may be one type or a plurality of types. That is, while the power-generating element 2 is in the first state, the crystalline state of the power-generating element 2 may change. Further, the crystalline state of the power-generating element 2 in the second state may be one type or a plurality of types. That is, while the power-generating element 2 is in the second state, the crystalline state of the power-generating element 2 may change.

With the change of the crystalline state described above, electric energy is generated from the power-generating element 2. Thereafter, the electric energy generated in the power-generating element 2 is recovered to the power storage device 52 (a recovery process) in this method.

More specifically, under control by the control device 6, the recovery switch 54 is closed at a desired timing, and the application switch 44 is opened. The power generated in the power-generating element 2 is thus recovered to the power storage device 52 via the electrodes 51 and the conducting wire 53.

The power generated in the power-generating element 2 can be boosted by a booster or be converted by an alternating current/direct current converter, as necessary, although not illustrated. The recovered power can be used by desired electric equipment, as necessary. The power generated in the power-generating element 2 can also be directly used by desired electric equipment without being recovered by the power storage device 52.

The power-generating method and the power-generating system 1 described above apply an electric field to the power-generating element 2 so as to change the phase transition temperature of the power-generating element 2 without changing the temperature of the power-generating element 2, thereby generating power from the power-generating element 2. Therefore, power generation can be performed without finding an environment that causes temperature change of the power-generating element 2. In addition, the method of changing the electric field applied to the power-generating element 2 to control electric polarization has less restrictions on the mass and the thermal conductivity of the power-generating element 2 as compared with a method of changing the temperature of the power-generating element 2, and is excellent in applicability.

In particular, in the power-generating method and the power-generating system 1 described above, the power-generating element 2 can convert ambient thermal energy to electrical energy, and therefore waste heat energy generated in various industrial fields, for example, can be efficiently recovered.

### Examples

### 1. BT(barium titanate, BaTiO₃)

### Example 1

In the power-generating system illustrated in FIG. 1, barium titanate [BaTiO₃] represented in Tables 1 and 2 was used as a power-generating element. More specifically, a sintered body of barium titanate was produced by the following method.

Powder of commercially available barium titanate [BaTiO₃] (BT-05 manufactured by Sakai Chemical Industry Co., Ltd.) was dry-crushed for 1 hour in an automatic mortar made of alumina. Ethanol was then added to the powder, and wet grinding was performed for 30 minutes. The powder was then dried in a drying oven at 100°C for 15 minutes. The powder was uniaxially pressed and isostatically pressed into a disc shape.

Next, the obtained molded product (green compact) of the powder was fired (main firing) in an electric furnace to be sintered. In the firing, the temperature was raised at a rate of 5°C/min and maintained at 1400°C for 3 hours in the air. Thus, a dense sintered body (main fired body) was obtained.

Next, the sintered body was polished and annealed. In the annealing, the temperature was raised at a rate of 10°C/min and maintained at 1000°C for 30 minutes in an oxidizing atmosphere (50% oxygen and 50% nitrogen).

Then, a silver electrode was deposited on the sintered body by vapor deposition at room temperature in an argon atmosphere. Thereafter, the sintered body was subjected to polarization treatment in an oil bath. The strength of an electric field in the polarization treatment was 30 kV/mm. The time of the polarization treatment was 30 minutes. Barium titanate (BaTiO₃) was thus obtained as a power-generating element.

The effective size of the power-generating element was 14.0 mm × 14.0 mm × 0.44 mm (thickness). The effective size refers to the volume of the portion sandwiched between electrodes.

The strength of the electric field applied by the electric-field application device was set to 1200 V/mm, 1400 V/mm, or 1600 V/mm, and the electric-field application cycle was set to 0.5 Hz (voltage was raised for 0.5 seconds and applied for 0.3 seconds, and application was stopped for 1.2 seconds).

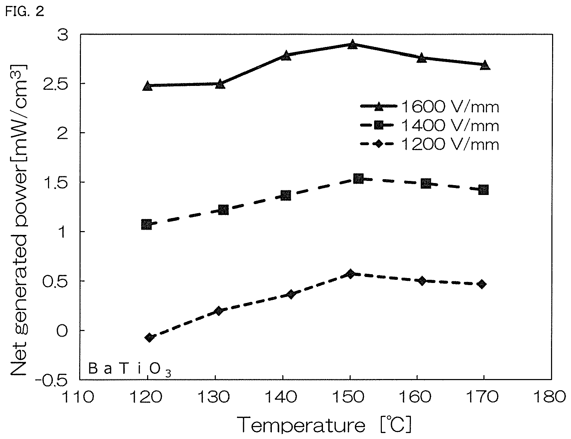

Then, the outside air temperature (environmental temperature) of the power-generating element was set to be constant, and the phase transition temperature of the power-generating element was changed by applying the electric field described above. As a result, the power-generating element was electrically polarized, and power was recovered. The temperature conditions were set at every 10°C between 120°C and 170°C. Thereafter, the net generated power was calculated by subtracting the power consumed by the electric-field application device from the recovered power. The results are shown in FIG. 2.

### Comparative Example 1

As the power-generating element, barium titanate [BaTiO3] was prepared as in Example 1. Then, the power-generating element was heated and cooled with time, so that its temperature was changed. For heating, a heat source capable of blowing high-temperature (T_{high}) air was prepared. Further, for cooling, a heat source capable of blowing low-temperature (T_{low}) air was prepared. The temperature of each heat source was set to be constant. The power-generating element was heated and cooled by switching air blowing from each heat source. The amount of temperature change (ΔT) by heating was 40°C. The heating and cooling cycle was set to 0.05 Hz (heating for 10 seconds and cooling for 10 seconds). The air blowing temperature on the high temperature (T_{high}) side was set at every 10°C between 150°C and 190°C.

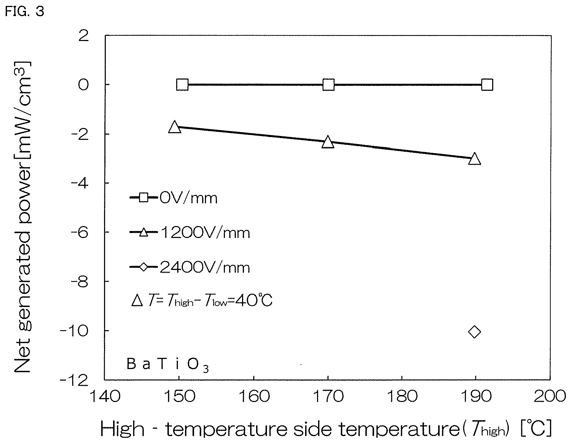

As a result, the power-generating element was electrically polarized, and power was recovered. At the start of heating, the recovered power was measured under the condition where an electric field was applied to the power-generating element and under the condition where no electric field was applied. When an electric field was applied to the power-generating element, the strength of the electric field was set to 1200 V/mm or 2400 V/mm. Thereafter, a net generated power was calculated by subtracting the power consumed during application of the electric field from the recovered power. The results are shown in FIG. 3.

### 2. BZT (barium zirconate titanate, Ba(Zr,Ti)O₃)

### Example 2

In the power-generating system illustrated in FIG. 1, barium zirconate titanate [Ba(Zr,Ti)O₃] represented in Tables 1 and 2 was used as a power-generating element. More specifically, a sintered body of barium titanate [Ba(Zr, Ti)O₃] was produced by the following method.

That is, as raw materials of barium zirconate titanate (Ba(Zr,Ti)O₃), main raw materials and a doping metal raw material represented in Table 3 were prepared so that the ratio of each element became the ratio represented in Table 1 and Table 2.

Next, the prepared raw materials and ethanol were put into an alumina pot mill (400 mL) and were pulverized and mixed by a ball mill, so that a raw material slurry was obtained. As grinding balls, YSZ balls with a diameter of 3 mm were used. The number of revolutions was 72 rpm. The mixing time was 70 hours.

Then, the YSZ balls were removed from the raw material slurry. Next, the raw material slurry was treated in an automatic mortar made of alumina, so that ethanol was removed. Thus, raw material powder was obtained.

The raw material powder was then calcined (primary calcination) in an electric furnace. In the calcination, the temperature was raised at a rate of 5°C/min and maintained at 1050°C for 4 hours in the air. Calcined powder was thus obtained.

The calcined powder was then dry-crushed for 1 hour in an automatic mortar made of alumina. Ethanol was then added to the calcined powder, and wet grinding was performed for 30 minutes. The calcined powder was then dried in a drying furnace at 100°C for 15 minutes. The dried powder was uniaxially pressed and isostatically pressed into a disc shape in the same manner as in Example 1.

Thereafter, the thus molded product was sintered in the same manner as in Example 1, so that a sintered body of barium zirconate titanate (Ba(Zr,Ti)O₃) was obtained. The obtained sintered body was subjected to annealing and polarization treatment in the same manner as in Example 1.

Barium zirconate titanate (Ba(Zr,Ti)O₃) was thus obtained as a power-generating element. The effective size of the power-generating element was 26.0 mm (diameter) × 0.48 mm (thickness).

The strength of an electric field applied by an electric-field application device was set to 1400 V/mm or 1600 V/mm, and the electric-field application cycle was set to 0.5 Hz (voltage was raised for 0.5 seconds and applied for 0.3 seconds, and application was stopped for 1.2 seconds).

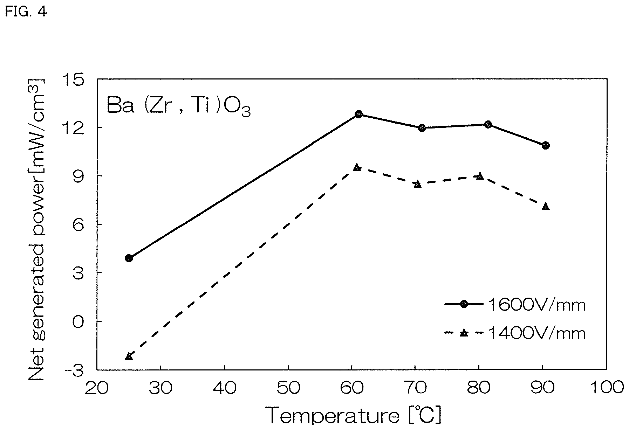

Then, the outside air temperature (environmental temperature) of the power-generating element was set to be constant, and the phase transition temperature of the power-generating element was changed by application of the electric field described above. As a result, the power-generating element was electrically polarized, and power was recovered. The temperature conditions were set at room temperature of 25°C and every 10°C between 60°C and 90°C. Thereafter, the net generated power was calculated by subtracting the power consumed by the electric-field application device from the recovered power. The results are shown in FIG. 4.

### 4. BCZT (barium calcium zirconate titanate (Ba,Ca)(Zr,Ti)O₃)

### Example 3

In the power-generating system illustrated in FIG. 1, barium calcium zirconate titanate [(Ba,Ca)(Zr,Ti)O₃] represented in Tables 1 and 2 was used as a power-generating element.

More specifically, as raw materials of barium calcium zirconate titanate [(Ba,Ca)(Zr,Ti)O₃), main raw materials and doping metal raw materials represented in Table 3 were prepared in such a manner that the ratio of each element became the ratio represented in Table 1 and Table 2.

A sintered body of barium calcium zirconate titanate [(Ba,Ca)(Zr,Ti)O₃] was obtained in the same manner as in Example 2 except for the above. The obtained sintered body was subjected to annealing and polarization treatment in the same manner as in Example 2.

Barium calcium zirconate titanate [(Ba,Ca)(Zr,Ti)O₃) was thus obtained as a power-generating element. The effective size of the power-generating element was 18.5 mm × 18.0 mm × 0.50 mm.

The strength of an electric field applied by an electric-field application device was set to 800 V/mm, 1000 V/mm or 1200 V/mm, and the electric-field application cycle was set to 0.5 Hz (voltage was raised for 0.4 seconds and applied for 0.3 seconds, and application was stopped for 1.3 seconds).

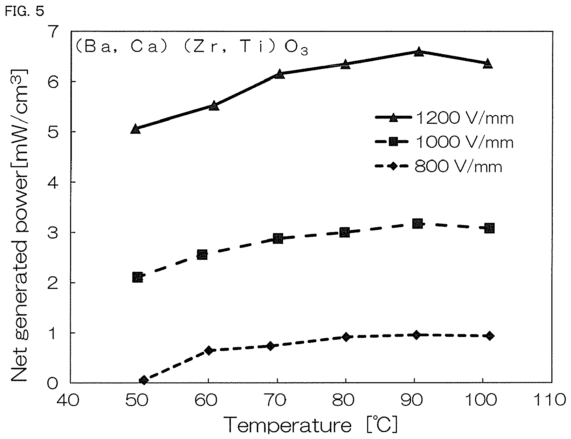

Then, the outside air temperature (environmental temperature) of the power-generating element was set to be constant, and the phase transition temperature of the power-generating element was changed by application of the electric field described above. As a result, the power-generating element was electrically polarized, and power was recovered. The temperature conditions were set at every 10°C between 50°C and 110°C. Thereafter, the net generated power was calculated by subtracting the power consumed by the electric-field application device from the recovered power. The results are shown in FIG. 5.

### 4. Rare-earth-doped BZT (barium zirconate titanate (Ba(Zr,Ti)O₃)

### Examples 4 to 11

In the power-generating system illustrated in FIG. 1, rare-earth-doped barium zirconate titanate [Ba(Zr,Ti)O₃] represented in Tables 1 and 2 was used as a power-generating element.

More specifically, as raw materials of rare-earth-doped barium zirconate titanate [Ba(Zr,Ti) O₃), main raw materials, a doping metal raw material, and doping rare earth raw materials represented in Table 3 were prepared in such a manner that the ratio of each element became the ratio represented in Table 1 and Table 2.

A sintered body of rare-earth-doped barium zirconate titanate [Ba(Zr,Ti)O₃] was obtained in the same manner as in Example 2 except for the above. The obtained sintered body was subjected to annealing and polarization treatment in the same manner as in Example 2.

Thus, rare-earth-doped barium zirconate titanate [Ba(Zr,Ti)O₃] as a power-generating element was obtained. The effective size of the power-generating element was 19.0 mm (diameter) × 0.5 mm (thickness).

The strength of an electric field applied by an electric-field application device was set to 1400 V/mm or 1600 V/mm, and the electric-field application cycle was set to 0.5 Hz (voltage was raised for 0.5 seconds and applied for 0.3 seconds, and application was stopped for 1.2 seconds). In Examples 8 to 11, the strength of the electric field was set to 1600 V/mm.

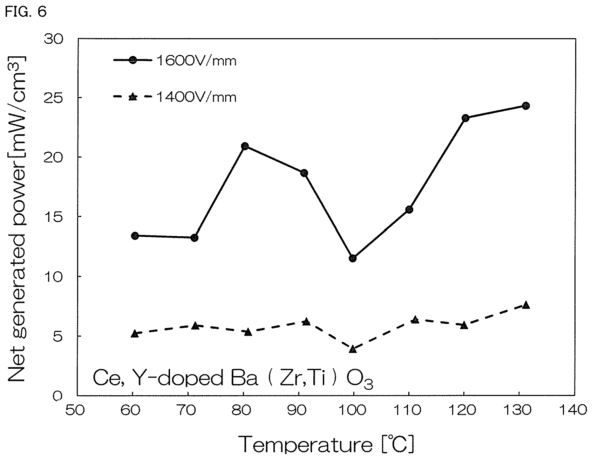

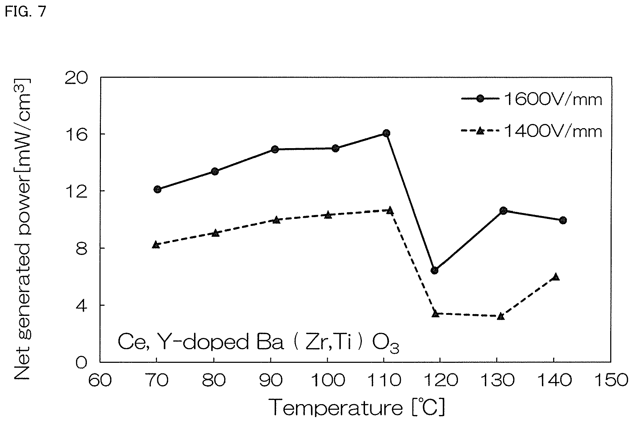

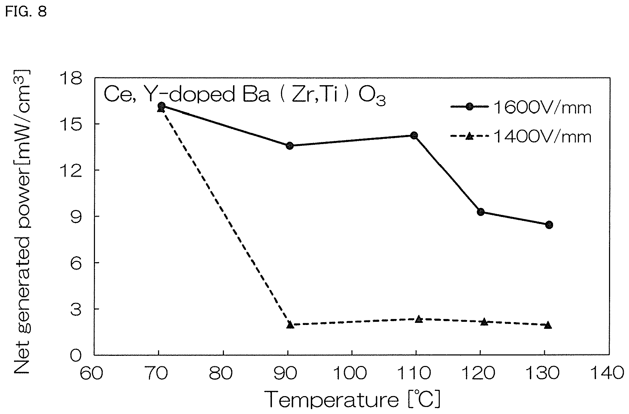

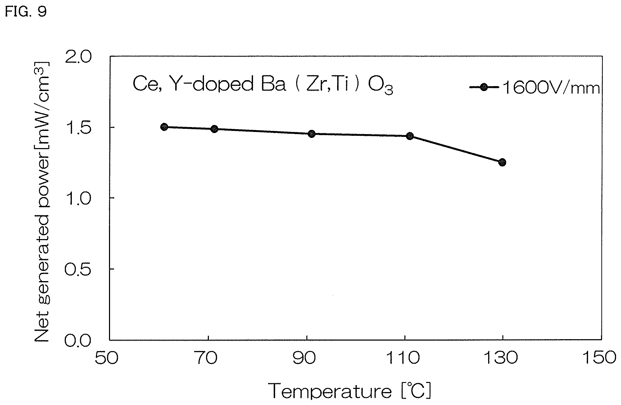

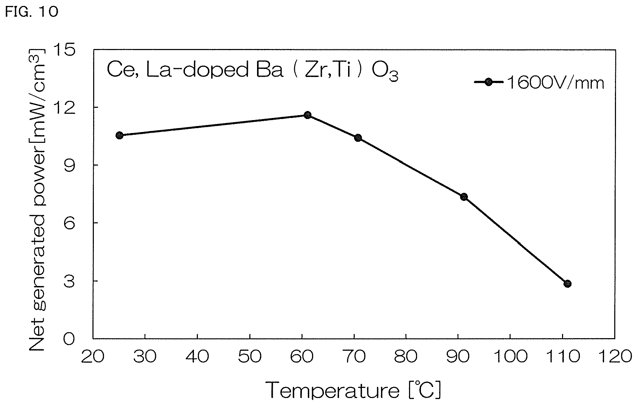

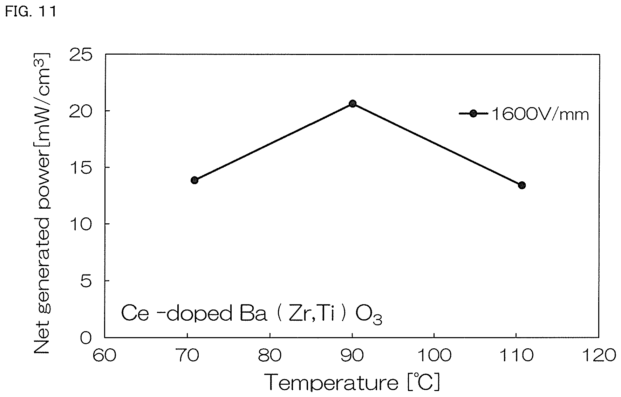

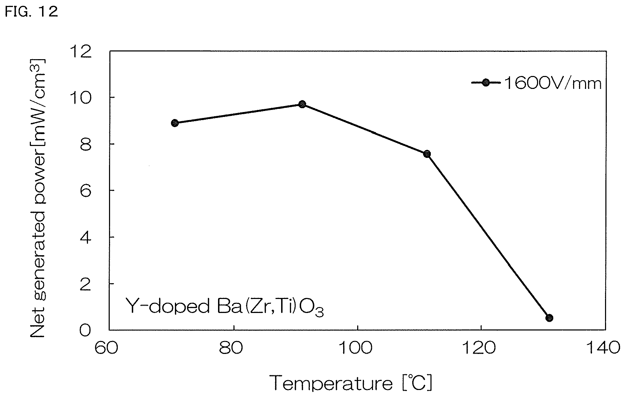

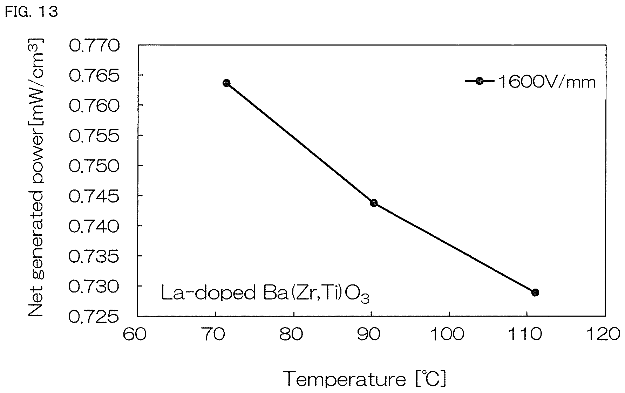

Then, the outside air temperature (environmental temperature) of the power-generating element was set to be constant, and the phase transition temperature of the power-generating element was changed by application of the electric field described above. As a result, the power-generating element was electrically polarized, and power was recovered. Thereafter, the net generated power was calculated by subtracting the power consumed by the electric-field application device from the recovered power. The results are shown in FIGS. 5 to 13.

### [Table 1]

**Table 1**

| No. | Composition (molar ratio) | | | | | | |
|---|---|---|---|---|---|---|---|
| | Dielectric | | Doping metal | | Doping rare earth element | | |
| | Ba | Ti | Ca | Zr | Ce | Y | La |
| Example 1 | 1.00 | 1.00 | 0 | 0 | 0 | 0 | 0 |
| Example 2 | 1.00 | 0.88 | 0 | 0.12 | 0 | 0 | 0 |
| Example 3 | 0.88 | 0.88 | 0.12 | 0.12 | 0 | 0 | 0 |
| Example 4 | 1.000000 | 0.879870 | 0 | 0.119990 | 0.000110 | 0.000030 | 0 |
| Example 5 | 1.000000 | 0.879913 | 0 | 0.119988 | 0.000090 | 0.000009 | 0 |
| Example 6 | 1.000000 | 0.879760 | 0 | 0.119880 | 0.000330 | 0.000030 | 0 |
| Example 7 | 1.0000 | 0.7392 | 0 | 0.1200 | 0.1291 | 0.0117 | 0 |
| Example 8 | 0.999 | 0.875 | 0 | 0.115 | 0.010 | 0 | 0.001 |
| Example 9 | 1.00000 | 0.87989 | 0 | 0.12000 | 0.00011 | 0 | 0 |
| Example 10 | 1.00000 | 0.87996 | 0 | 0.12001 | 0 | 0.00003 | 0 |
| Example 11 | 0.90 | 0.88 | 0 | 0.12 | 0 | 0 | 0.10 |

### [Table 2]

**Table 2**

| No. | Composition (mol%) | | | | | | |
|---|---|---|---|---|---|---|---|
| | Dielectric | | Doping metal | | Doping rare earth element | | |
| | Ba | Ti | Ca | Zr | Ce | Y | La |
| Example 1 | 50.0000% | 50.0000% | 0.0000% | 0.0000% | 0.0000% | 0.0000% | 0.0000% |
| Example 2 | 50.0000% | 44.0000% | 0.0000% | 6.0000% | 0.0000% | 0.0000% | 0.0000% |
| Example 3 | 44.0000% | 44.0000% | 6.0000% | 6.0000% | 0.0000% | 0.0000% | 0.0000% |
| Example 4 | 50.0000% | 43.9935% | 0.0000% | 5.9995% | 0.0055% | 0.0015% | 0.0000% |
| Example 5 | 50.0000% | 43.9957% | 0.0000% | 5.9994% | 0.0045% | 0.0005% | 0.0000% |
| Example 6 | 50.0000% | 43.9880% | 0.0000% | 5.9940% | 0.0165% | 0.0015% | 0.0000% |
| Example 7 | 50.0000% | 36.9600% | 0.0000% | 6.0000% | 6.4550% | 0.5850% | 0.0000% |
| Example 8 | 49.9500% | 43.7500% | 0.0000% | 5.7500% | 0.5000% | 0.0000% | 0.0500% |
| Example 9 | 50.0000% | 43.9945% | 0.0000% | 6.0000% | 0.0055% | 0.0000% | 0.0000% |
| Example 10 | 50.0000% | 43.9980% | 0.0000% | 6.0005% | 0.0000% | 0.0015% | 0.0000% |
| Example 11 | 45.0000% | 44.0000% | 0.0000% | 6.0000% | 0.0000% | 0.0000% | 5.0000% |

### [Table 3]

**Table 3**

| No. | Main row material | | Doping metal raw material | | | Doping rare earth raw material | | |
|---|---|---|---|---|---|---|---|---|
| | Ba | Ti | Ca | Zr | | Ce | Y | La |
| Example 1 | BaTiO₃ | | - | - | | - | - | - |
| Example 2 | BaCO₃ | TiO₂ | - | ZrO2 | | - | - | - |
| Example 3 | BaCO₃ | TiO₂ | CaCO₃ | ZrO₂ | | - | - | - |
| Example 4 | BaCO₃ | TiO₂ | - | ZrO₂ | Ce_{0.44}Zr_{0.44}Y_{0.12}O_{2-δ} | | | - |
| Example 5 | BaCO₃ | TiO₂ | - | ZrO₂ | | Ce₂(CO₃)₃·8H₂0 | Y₂O₃ | - |
| Example 6 | BaCO₃ | TiO₂ | - | ZrO₂ | Ce_{0.495}Zr_{0.460}Y_{0.045}O_{2-δ} | | | - |
| Example 7 | BaCO₃ | TiO₂ | - | Ce_{0.495}Zr_{0.460}Y_{0.045}O_{2-δ} | | | | - |
| Example 8 | BaCO₃ | TiO₂ | - | ZrO₂ | | Ce₂(CO₃)₃·8H₂0 | - | La₂O₃ |
| Example 9 | BaCO₃ | TiO₂ | - | ZrO₂ | | Ce₂(CO₃)₃·8H₂0 | - | - |
| Example 10 | BaCO₃ | TiO₂ | - | ZrO₂ | | - | Y₂O₃ | - |
| Example 11 | BaCO₃ | TiO₂ | - | ZrO₂ | | - | - | La₂O₃ |

### Examples 12 to 15

In the power-generating system represented in FIG. 1, the strength of an applied electric field and the frequency of an electric-field application cycle were changed, and the behavior of the system was observed.

More specifically, rare-earth-doped barium zirconate titanate [Ba(Zr, Ti)O₃] in Example 11 was used as a power-generating element. Then, the outside air temperature (environmental temperature) of the power-generating element was set to 25°C, and the phase transition temperature of the power-generating element was changed by application of the electric field.

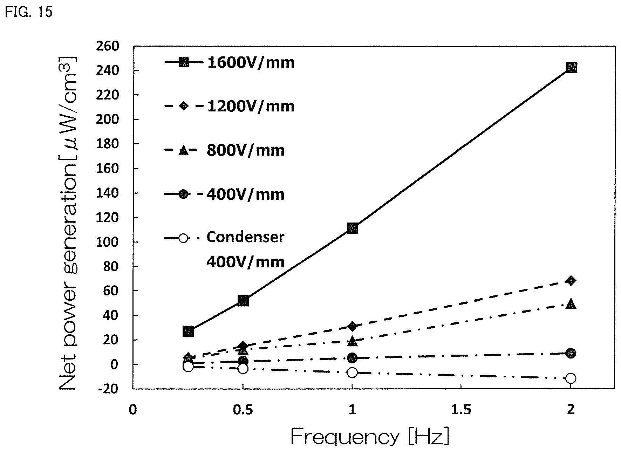

Further, the strength of the electric field applied by the electric-field application device and the frequency of the electric-field application cycle were changed as follows. As a result, the power-generating element was electrically polarized, and power was recovered. Thereafter, the net generated power was calculated by subtracting the power consumed by the electric-field application device from the recovered power. The results are shown in FIG. 15.

The strength of the electric field applied to the power-generating element by the electric-field application device was set as follows. In Example 12, the strength of the electric field was set to 400 V/mm. In Example 13, the strength of the electric field was set to 800 V/mm. In Example 14, the strength of the electric field was set to 1200 V/mm. In Example 15, the strength of the electric field was set to 1600 V/mm.

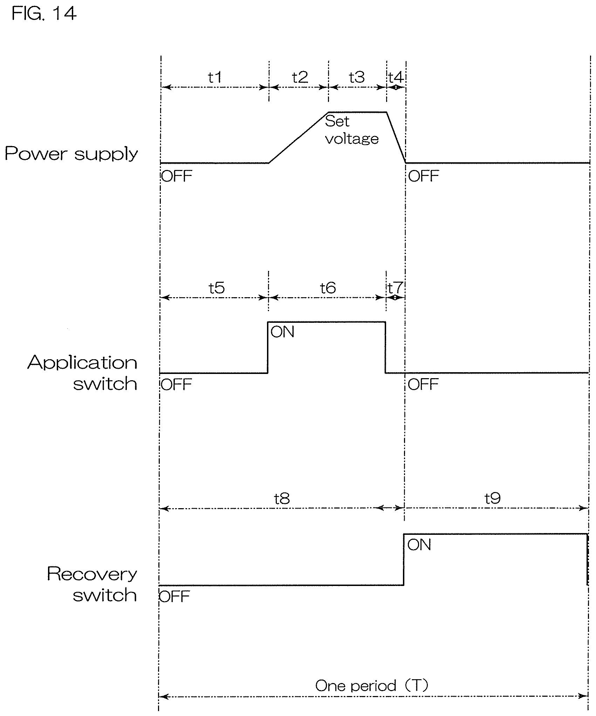

The electric-field application cycle was set to 0.25 Hz, 0.5 Hz, 1.0 Hz, and 2.0 Hz. Operations in each application cycle (operations of the power supply, the application switch, and the recovery switch) are shown in FIG. 14 as one cycle (one period) unit. The details of each operation in FIG. 14 are represented in Table 4.

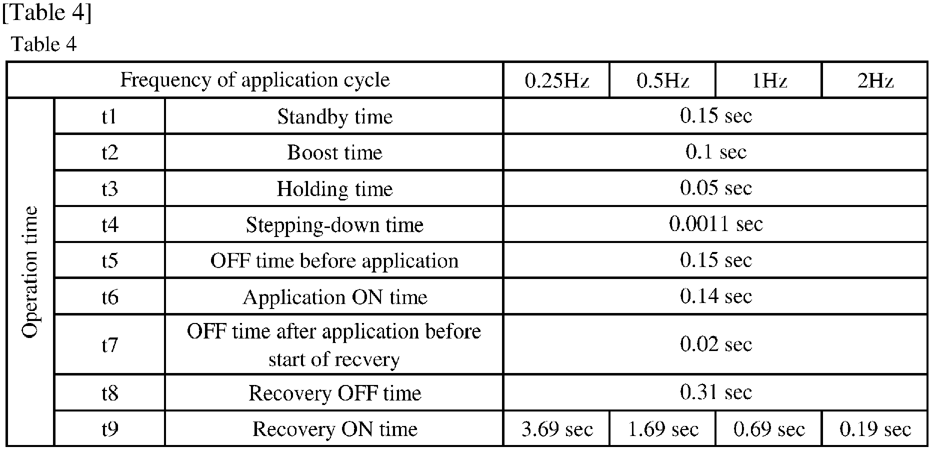

### Comparative Example 2

A commercially available condenser (multilayer ceramic condenser, Murata Manufacturing Co., Ltd., RDER72J103K2K1H03B, capacitance: 0.01 µF) was used in place of a power-generating element, and net generated power was calculated by the same method (400 V/mm) as in Example 12. The strength of an electric field applied by an electric-field application device was set to 400 V/mm. The results are shown in FIG. 15.

While the illustrative embodiments of the present invention are provided in the above description, such is for illustrative purpose only and it is not to be construed as limiting in any manner. Modification and variation of the present invention that will be obvious to those skilled in the art is to be covered by the following claims.

### Industrial Applicability

A power-generating method and a power-generating system according to the present invention are suitably used in various industrial fields requiring power.

### Description of the Reference Numerals

1: Power-generating system
2: Power-generating element
3: Power generator
4: Electric-field application device
5: Extraction device
6: Control device

## Claims

1. A power-generating method of generating power from a power-generating element whose electric polarization state is changed by phase transition, the method comprising:
an electric-field application process of applying an electric field to the power-generating element to change a phase transition temperature of the power-generating element by an electric-field application unit for applying the electric field to the power-generating element without changing a temperature of the power-generating element; and
a power-generating process of changing the electric polarization state in the power-generating element by application of the electric field and control of the application, to generate the power from the power-generating element.

2. The power-generating method according to Claim 1, wherein the electric-field application process changes the phase transition temperature of the power-generating element to repeat
a first state where the phase transition temperature exceeds an outside air temperature and
a second state where the phase transition temperature is less than the outside air temperature.

3. The power-generating method according to Claim 1, wherein a temperature difference between the phase transition temperature of the power-generating element to which no electric is applied and an outside air temperature of the power-generating element is 50°C or less.

4. The power-generating method according to Claim 1, wherein the power-generating element contains at least one selected from the group consisting of barium titanate [BaTiO₃], barium zirconate titanate [Ba (Zr,Ti)O₃], and barium calcium zirconate titanate [(Ba,Ca)(Zr,Ti)O₃].

5. The power-generating method according to Claim 4, wherein the power-generating element further contains a doping rare earth element.

6. The power-generating method according to Claim 5, wherein the doping rare earth element contains at least one selected from the group consisting of Ce, Y, and La.

7. The power-generating method according to Claim 5, wherein the doping rare earth element contains Ce, and
a content ratio of Ce with respect to a total amount of metal elements in the power-generating element is 0.00005 mol% or more and 50 mol% or less.

8. The power-generating method according to Claim 4, wherein the power-generating element is annealed in an oxidizing atmosphere.

9. A power-generating system comprising a power-generating element whose electric polarization state is changed by phase transition and a power-generating unit for generating power from the power-generating element, wherein
the power-generating unit includes:
no temperature changing unit that changes an outside air temperature of the power-generating element;
an electric-field application unit that applies an electric field to the power-generating element to change a phase transition temperature of the power-generating element;
an extraction unit for extracting the power generated due to change of the electric polarization state in the power-generating element; and
a control unit for controlling the electric field applied by the electric-field application unit, and
the control unit applies the electric field to the power-generating element to cause change of the phase transition temperature of the power-generating element.

10. The power-generating system according to Claim 9, wherein the control unit applies the electric field to the power-generating element to change the phase transition temperature of the power-generating element, causing a first state where the phase transition temperature exceeds the outside air temperature and a second state where the phase transition temperature is less than the outside air temperature to be repeated.

11. The power-generating system according to Claim 9, wherein the power-generating element contains at least one selected from the group consisting of barium titanate [BaTiO₃], barium zirconate titanate [Ba(Zr,Ti)O₃], and barium calcium zirconate titanate [(Ba,Ca)(Zr,Ti)O₃].

12. The power-generating system according to Claim 11, wherein the power-generating element further contains a doping rare earth element.

13. The power-generating system according to Claim 12, wherein the doping rare earth element contains at least one selected from the group consisting of Ce, Y, and La.

14. The power-generating system according to Claim 12, wherein the doping rare earth element contains Ce, and
a content ratio of Ce with respect to a total amount of metal elements in the power-generating element is 0.00005 mol% or more and 50 mol% or less.

15. The power-generating system according to Claim 11, wherein the power-generating element is annealed in an oxidizing atmosphere.
